# EUROPEAN PATENT APPLICATION

(11) **EP 4 175 245 A1**
(43) Date of publication of application: **03.05.2023**
(21) Application number: 22204067.7
(22) Date of filing: 27.10.2022
(51) Int. Cl.: H04L 41/14, H04L 41/16, H04W 24/02

(54) **DEEP REINFORCEMENT LEARNING BASED WIRELESS NETWORK SIMULATOR**

(30) Priority: 28.10.2021 FI 20216115
(71) Applicant: Nokia Solutions and Networks Oy, 02610 Espoo (FI)
(72) Inventor: Liu, Qiang, Lincoln, NE, 68526 (US); Choi, Nak Jung, Florham Park, NJ, 07932 (US)
(74) Representative: Papula Oy

(57) **Abstract**

According to an example embodiment, a device is configured to a deep reinforcement learning, DRL, agent to simulate the behaviour of a network component. The DRL agent takes the network state and user traffic as inputs. It generates the next network state and user performances. A training algorithm of the simulator is configured for the DRL agents and it is derived to deal with the property of time-correlation in network components. The simulator uses a training algorithm so that it enables robust inference under a limited number of transitions collected with the real network components and users. It is derived with state augmentation by using an autoencoder architecture. It is also configured by a reward estimation algorithm by using local regression, for example with a Gaussian Process.

## Description

### TECHNICAL FIELD

The present disclosure generally relates to the field of wireless communications. In particular, the present disclosure relates to a device, and related method and computer programs for simulating the wireless network.

### BACKGROUND

Modern wireless networks have massive deployed base stations in radio access network (RAN), e.g. eNBs in LTE and gNBs in 5G NR, to wirelessly connect mobile users into the network, distributed network functions (NFs) in core networks (CN) to support nation-wide mobility traffic processing, and network switches in transport networks (TN) to connect the RAN and the CN. These network components are very complicated to be precisely mathematically modelled. For example, the base stations are composed of multiple protocol stacks (e.g., PHY, MAC, RLC, RRC), whose generation could range from BTS, eNB in LTE to gNB in NR. As a result, it is difficult to formulate the wireless transmission between mobile users and BSs. As these components are inter-connected with each other, e.g. wireless transmission in RAN, traffic transportation in TN and packet processing in CN, the whole network becomes extremely complex and is very challenging to be mathematically formulated in an accurate way.

Existing network management solutions are usually derived within a network simulator, which is usually built based on the (simplified) mathematical formulations of the cellular network. For example, a user scheduling algorithm can be derived in a RAN simulator to improve the throughput of BSs, which simulates the traffic arrival and channel dynamics of mobile users. For example, NS-3 is a widely used network simulator, in which the events are inserted, executed, monitored and departed to simulate the transmission of different networks. However, it abstracts the very detailed processing of the transmission packet in physical layers. As a result, such simulator is incapable of accurately emulating the real large-scale cellular network. These model-based approaches suffer from the significant discrepancy between the network simulator and the real network. In other words, these derived solutions could be compromised in terms of the degradation of performance and effectiveness. As a result, they fail to efficiently optimize the network performances in the ever-complicating networks toward 5G and beyond.

### SUMMARY

The scope of protection sought for various example embodiments of the disclosure is set out by the independent claims. The example embodiments and features, if any, described in this specification that do not fall under the scope of the independent claims are to be interpreted as examples useful for understanding various example embodiments of the disclosure.

An example embodiment of a simulator device comprises at least one processor and at least one memory comprising computer program code. The at least one memory and the computer program code are configured, with the at least one processor, to cause the simulator device to: configure deep reinforced learning, DRL, agents. Each DRL agent is configured to emulate an operation of a component of the wireless network. Each DRL agent is configured to states representing information of the wireless network and information of the component. The DRL agents are configured to receive and execute training data so that the states are augmented and reward estimated. The simulator device is configured to inter-connect the DRL agents to emulate real connections between the components in the wireless network, and execute the DRL agents based on the states as inputs to simulate the wireless network online. For example, the simulator device may emulate the end-to-end network with high fidelity. A distributed model-free simulation framework with DRL technique may be obtained. A robust training algorithm for agents with state augmentation and reward estimation may be obtained.

In an example embodiment, alternatively or in addition to the above-described example embodiments, each DRL agent is configured to emulate an individual component in a real wireless network, wherein the component comprises the individual component and the wireless network comprises the real wireless network implemented in a certain geographical area. Network and user agents may emulate the behaviour of real network components and users.

In another example embodiment, alternatively or in addition to the above-described example embodiments, the states comprise an inner state representing technical inner information of the component and each DRL agent is configured to receive the inner state as an input. Technical features of an individual component may be considered for the simulation.

In an example embodiment, alternatively or in addition to the above-described example embodiments, the states comprise an outer state representing a wireless network user status and states of other DRL agents, and each DRL agent is configured to receive the outer state as an input. For example, interaction with other network components and user devices may be considered in the simulation.

In an example embodiment, alternatively or in addition to the above-described example embodiments, each DRL agent is further configured to output a next inner state based on said states, the next inner state representing the network configuration of the DRL agent based on said states. Interactions and dynamics of the network component may be simulated.

In an example embodiment, alternatively or in addition to the above-described example embodiments, a user agent is further configured to emulate operations of a user device of the wireless network, and the user agent is configured to generate data traffic of the wireless network and performances of the user within the wireless network. For example, user actions can be simulated by the device in the network.

In an example embodiment, alternatively or in addition to the above-described example embodiments, the DRL agents are configured to receive the data traffic and the performances of the user within the wireless network. User interaction in the network may also be simulated.

In an example embodiment, alternatively or in addition to the above-described example embodiments, the user device comprises a mobile device.

In an example embodiment, alternatively or in addition to the above-described example embodiments, for augmenting, the device is further configured to use an autoencoder to augment the states. A robust training algorithm may be achieved.

In an example embodiment, alternatively or in addition to the above-described example embodiments, the autoencoder comprises a variational autoencoder, VAE.

In an example embodiment, alternatively or in addition to the above-described example embodiments, for the reward estimating the device is further configured to use distributional regression. A robust training algorithm may be obtained for the training configuration.

In an example embodiment, alternatively or in addition to the above-described example embodiments, the device is configured to gaussian process regression, GPR, for the reward estimation.

In an example embodiment, alternatively or in addition to the above-described example embodiments, the device is configured to augment the states so that a massive number of states is obtained for the DRL agent; and
the device is configured to reward estimate the massive number of states by distributional regression based on similarity of the states. The simulator device may achieve a robust training configuration for the simulation.

In an example embodiment, alternatively or in addition to the above-described example embodiments, the wireless network comprises a mobile network.

In an example embodiment, alternatively or in addition to the above-described example embodiments, the DRL agent is configured to emulate a base station, a switch, or a data processor unit of the wireless network.

An example embodiment of a simulator device comprises means for performing:
configuring deep reinforced learning, DRL, agents, wherein each DRL agent is configured to emulate an operation of a component of the wireless network, and each DRL agent is configured to states representing information of the wireless network and information of the component;
receiving and executing, by the DRL agents, training data so that the states are augmented and reward estimated;
inter-connecting the DRL agents to emulate real connections between the components in the wireless network; and
executing the DRL agents based on the states as inputs to simulate the wireless network online.

An example embodiment of a method comprises:
configuring deep reinforced learning, DRL, agents, wherein each DRL agent is configured to emulate an operation of a component of the wireless network, and each DRL agent is configured to states representing information of the wireless network and information of the component;
receiving and executing, by the DRL agents, training data, wherein the states are augmented and reward estimated;
inter-connecting the DRL agents to emulate real connections between the components in the wireless network; and
executing the DRL agents based on the states as inputs to simulate the wireless network online.

In an example embodiment, alternatively or in addition to the above-described example embodiments, offline training of the DRL agents is further performed before the state augmentation.

In an example embodiment, alternatively or in addition to the above-described example embodiments, each DRL agent is configured to emulate an individual component in a real wireless network, wherein the component comprises the individual component and the wireless network comprises the real wireless network implemented in a certain geographical area.

In an example embodiment, alternatively or in addition to the above-described example embodiments, the method is configured for a model-free simulation.

An example embodiment of a computer program product comprises program code configured to perform the method according to any of the above example embodiments, when the computer program product is executed on a computer.

### DESCRIPTION OF THE DRAWINGS

The accompanying drawings, which are included to provide a further understanding of the example embodiments and constitute a part of this specification, illustrate example embodiments and together with the description help to explain the principles of the example embodiments. In the drawings:
Fig. 1 illustrates an example embodiment of the subject matter described herein illustrating a device configured to simulate a wireless network;
Fig. 2 illustrates an example embodiment of the subject matter described herein illustrating a simulator system;
Fig. 3 illustrates an example embodiment of the subject matter described herein illustrating a flow chart representation of a method for simulating a wireless network;
Fig. 4 illustrates a block diagram of a network agent according to an example embodiment;
Fig. 5 illustrates a block diagram of a user agent according to an example embodiment;
Fig. 6 illustrates a block diagram of a training algorithm according to an example embodiment;
Fig. 7 illustrates a block diagram of state augmentation according to an example embodiment; and
Fig. 8 illustrates a block diagram of reward estimation according to an example embodiment.

Like reference numerals are used to designate like parts in the accompanying drawings.

### DETAILED DESCRIPTION

Reference will now be made in detail to example embodiments, examples of which are illustrated in the accompanying drawings. The detailed description provided below in connection with the appended drawings is intended as a description of the present examples and is not intended to represent the only forms in which the present disclosure may be constructed or utilized. The description sets forth the functions of the example and the sequence of steps for constructing and operating the example. However, the same or equivalent functions and sequences may be accomplished by different example embodiments.

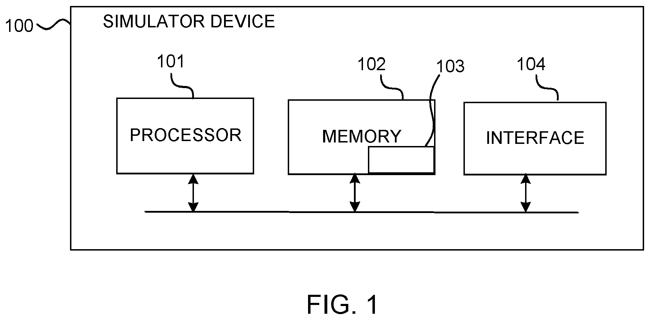

Fig. 1 is a block diagram of a device 100 configured to simulate a wireless network in accordance with an example embodiment. The device 100 may be referred to as a simulator device 100.

The simulator device 100 may comprise one or more processors 101 and one or more memories 102 that comprise computer program code 103. The simulator device 100 may also comprise at least one communication interface 104, as well as other elements, such as an input/output module (not shown in Fig. 1).

According to an example embodiment, the at least one memory 102 and the computer program code 103 are configured, with the at least one processor 101, to cause the simulator device 100 to configure a DRL agent to simulate the behaviour of a network component. The DRL agent takes the network state and user traffic as inputs. It generates the next network state and user performances. A training algorithm of the device 100 configured for the DRL agents is derived to deal with the property of time-correlation in network components.

Furthermore, the simulator device 100 is configured to the training algorithm so that it enables robust inference under a limited number of transitions collected with the real network components and users. It is derived with state augmentation by using an autoencoder architecture. It is also configured by a reward estimation algorithm by using local regression, for example with Gaussian Process.

The device 100 is configured to a deep reinforcement learning based network and a user simulator accordingly. Instead of the conventional model-based simulator design, the device 100 is configured to derive a model-free approach to simulate the cellular network in an end-to-end manner. The device 100 may achieve high scalability with respect to the incremental deployed network infrastructures, enable effective training for distributed DRL agents, and handle the extreme network dynamics.

The simulation device 100 has a distributed model-free framework that comprises multiple DRL agents to emulate the behaviour of different network components. This framework allows hot plug-in and -out on DRL agents, and can effectively scale according to the changes of the network topology. As compared to conventional model-based approaches, it achieves high-fidelity behaviour simulation by exploiting high-dimensional deep neural network architectures.

Although the simulator device 100 may be depicted to comprise only one processor 101, the network node device 100 may comprise more processors. In an example embodiment, the memory 102 is capable of storing instructions, such as an operating system and/or various applications.

Furthermore, the processor 101 may be capable of executing the stored instructions. In an example embodiment, the processor 101 may be embodied as a multi-core processor, a single core processor, or a combination of one or more multi-core processors and one or more single core processors. For example, the processor 101 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like. In an example embodiment, the processor 101 may be configured to execute a hard-coded functionality. In an example embodiment, the processor 101 is embodied as an executor of software instructions, wherein the instructions may specifically configure the processor 101 to perform the algorithms and/or operations described herein when the instructions are executed.

The memory 102 may be embodied as one or more volatile memory devices, one or more non-volatile memory devices, and/or a combination of one or more volatile memory devices and non-volatile memory devices. For example, the memory 102 may be embodied as semiconductor memories (such as mask ROM, PROM (programmable ROM), EPROM (erasable PROM), flash ROM, RAM (random access memory), etc.).

The device 100 may be embodied in, for example, a computer. Alternatively, or in addition, the computer may be a cloud computer system having various distributed units.

When the device 100 is configured to implement some functionality, some component and/or components of the device 100, such as the at least one processor 101 and/or the memory 102, may be configured to implement this functionality. Furthermore, when the at least one processor 101 is configured to implement some functionality, this functionality may be implemented using program code 103 comprised, for example, in the memory 102. For example, if the simulator device 100 is configured to perform an operation, the at least one memory 102 and the computer program code 103 can be configured, with the at least one processor 101, to cause the network node device 100 to perform that operation.

Some terminology used herein may follow the naming scheme of 4G or 5G technology in its current form. However, this terminology should not be considered limiting, and the terminology may change over time. Thus, the following discussion regarding any example embodiment may also apply to other technologies. Deep reinforcement learning, DRL, may relate to a subfield of machine learning that combines reinforcement learning (RL) and deep learning. The RL considers the problem of a computational agent learning to make decisions by trial and error. Deep RL incorporates deep learning into the solution, allowing agents to make decisions from unstructured input data without manual engineering of the state space. Deep RL algorithms are able to take in very large inputs, for example every pixel rendered to the screen in a video game, and decide what actions to perform to optimize an objective, for example maximizing the game score. DRL has been used for a diverse set of applications including but not limited to simulations, design, etc. The Gaussian process regression, GPR, may relate to a nonparametric, Bayesian approach to regression that is applicable in the area of machine learning. GPR has several benefits, working well on small datasets and having the ability to provide uncertainty measurements on the predictions.

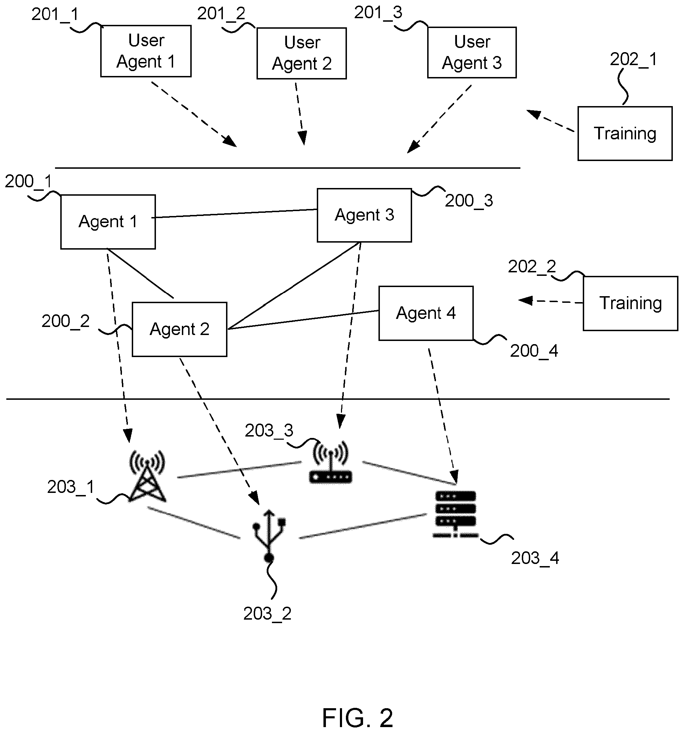

Fig. 2 illustrates an example embodiment of the subject matter described herein illustrating a network simulator of the simulator device 100.

As depicted in Fig.2, the network simulator is composed of multiple DRL agents (200_1, 200_2, 200_3, 200_4) that are interconnected. These agents 200 are designed with the DRL technique to emulate the behaviour of the real wireless network components (203_1, 203_2, 203_3, 203_4). The simulator system provides training 202_1 for the user agents 201 and training 202_2 for the DRL agents 200. Each agent 200 takes both an inner state and an outer state as inputs. Each agent 200 generates an action such as user performance and the next inner state, based on the inputs and configuration. User agents (201_1, 202_2 201_3) emulate the user performance in the network simulation. The agents 200 are interconnected, which means an agent 200 will observe the other agents' states when taking the next action. The connection among agents 200 reflects the real network component inter-dependencies, for example the X2 interface between eNBs, and for example the fibers between eNBs and switches.

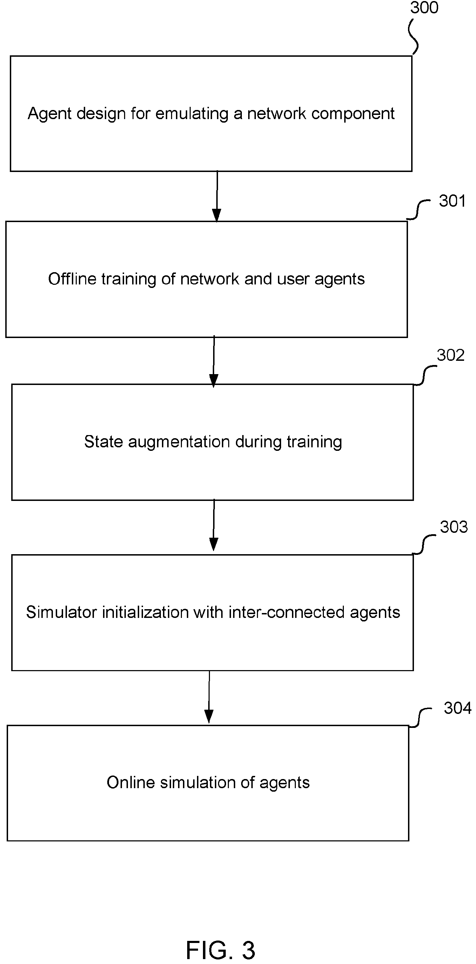

Fig. 3 illustrates an example embodiment of the subject matter described herein illustrating a flow chart representation of a method. The general training and simulation operations of the network simulator are illustrated in the example embodiment of Fig. 3.

At operation 300 each agent 200 is designed to emulate the behaviour of an individual network component 203. The state space and action space are defined accordingly.

At operation 301 an offline training stage is operated. The DRL agents 200 are trained independently by either using an offline data set or online interaction with the real network component 203. The user agents 201 may also be trained at this stage.

At operation 302 in order to enhance the robustness of the DRL agents 200 when handling extreme diverse network dynamics, the states are augmented. This may be performed, for example, with an autoencoders technique to traverse a plurality of possibilities for the states and agents 200,201.

At operation 303 the DRL agents 200 are included on-demand during the online simulation stage. Their connections are determined based on the real connections of their simulated network component 203 in the real network.

In the online simulation stage at operation 304, the agents 200 are executed based on the inputs, for example network traffic. The DRL agents 200 take both an inner and an outer state as inputs. The agents 200,201 generate the next inner state and user performance relevant information.

The method may be performed by, for example, the simulator device 100.

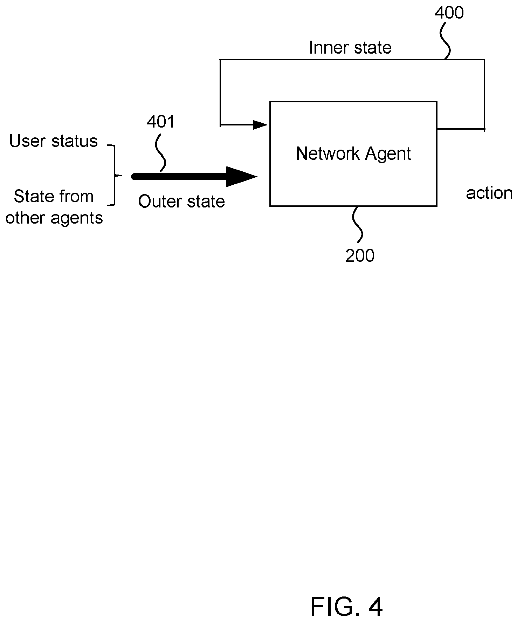

Fig. 4 illustrates an example of a network agent 200 according to an example embodiment. The network agent may also be referred to as the DRL agent 200.

The DRL agent 200 is configured to emulate the behavior of a network component 203 as shown in Fig. 2. The agent 200 is configured to react to the inputs, for example the user traffic, and transit to the next state as the real network component 203 does. The behavior of network components 203 is time-correlated. Consequently, the decision made at this time not only affects the next output but also a further state. Thus, the problem of behavior emulation may be formulated as a Markovian decision process (MDP). Considering the complicated mechanisms in each network component 203, for example BS and Switches, the agent 200 is configured to exploit a DRL technique to solve the high dimension problem, where the state and action space could be hundreds, or thousands of dimensions. Conventionally, an agent is designed to maximize the cumulative reward with an environment. In the example embodiment, the DRL agent 200 is configured to emulate and/or mimic an environment (for example, the network component 203 or user). To this end, the DRL agent 200 is configured to react just like the environment, not only instantaneously but also statistically. The agent 200 comprises a) a states space, b) an action space, c) a reward function and d) a functionality as follows.
a) The state space is configured to provide the inputs to the DRL agents 200, which represents comprehensive information about the network. The state space comprises two parts, an inner state 400 and an outer state 401. The inner state 400 is the state that may only be used and seen inside this particular network component 203. For example, the inner state 400 may include the run time metrics of an eNB, RLC buffer, and retransmission status. The outer state 401 includes the user status and state from other agents 200. The user status denotes the external inputs from the users, for example traffic arrival and channel condition, mobility, etc. These user statuses change at different simulation time slots. Furthermore, each agent 200 defines the states that are visible to other agents 200, for example, interference information among X2 connected eNBs, and user data transmission between RAN and TN.
b) The action space is configured to allow the DRL agent 200 to transit to the next inner state 400. For example, the action space of this DRL agent 200 is the next inner state.
c) The reward function is configured to guide the training of the neural network. The objective of a DRL agent 200 may be to maximize the cumulative reward. The target is to emulate the behaviour of the network component 203. Thus, the reward is the negative difference between the generated next inner state and the real inner state obtained from experimental traces.
d) The functionality: A DRL agent 200 needs to adapt to different connections with other agents 200, for example when an agent is connected to multiple agents in the network (BSs or switches). Conventional neural network architectures (convolutional, full-connected) are with fixed input and output sizes that cannot be used in this scenario. Thus, the example embodiment is configured to a recurrent neural network (RNN), which is the architecture of DRL agents 200. The RNN allows flexible input and output size.

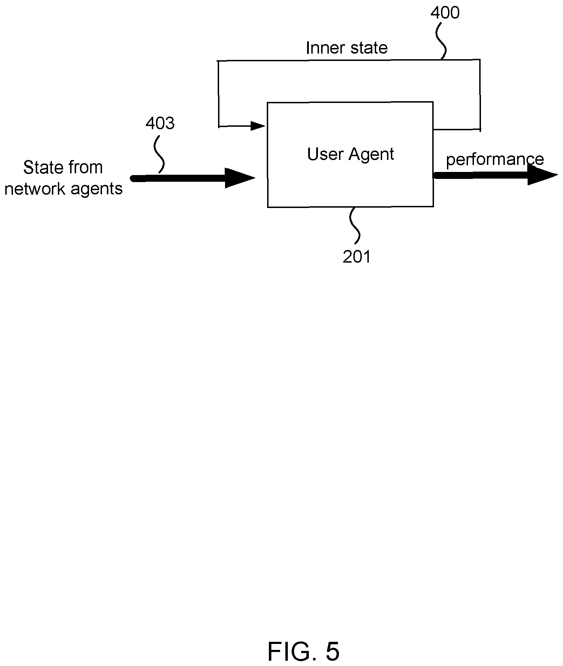

Fig. 5 illustrates an example of a user agent 201 according to an example embodiment.

The user agent 201 is configured to emulate the traffic generation and performances of a user as shown in Fig. 5. The user agent 201 is configured to observe the states from the agents 200, generate user traffic and obtain the performances as a real user does. As the state from agents 200 could be very high dimension, the problem is solved by leveraging the DRL technique as the agent 200 did before. The user agent 201 is configured for a state space, an action space, a reward function and a functionality as follows.
a) The state space is configured as the observable state 403 from all applied agents 200 and the inner state 400. For example, it can observe the state 403 from an agent 200 in RAN (RLC buffer, retransmission status), an agent 200 from TN (data transmitted). The inner state 400 is the state only to be used internally, such as the remaining data size for transmission and traffic pattern of user application. These states 400,403 help to estimate the performance of this user agent 201 such as throughput, delay and jitters.
b) The action space is configured as the performance of the user agent 201, for example throughput, delay and reliability.
c) The reward function is configured to emulate the behaviour of the users. Thus, the reward is the negative difference between the generated next inner state and performance, and the real inner state and performance obtained from experimental traces.
d) The functionality: As a user is served by the end-to-end network that involves multiple agents 200, the user agent 201 needs flexible input and output sizes. The user agent 201 is configured to the RNN architecture, similarly as the network agents 200.

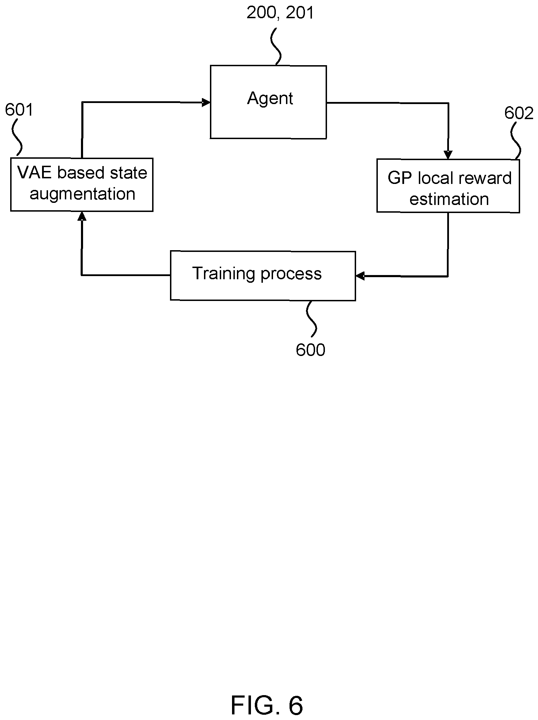

Fig. 6 illustrates a block diagram of a training algorithm and operation according to an example embodiment.

The agents 200,201 may need to be trained before they can be used in the simulation. Conventionally, these agents are trained with an offline collected dataset, which suffers from a significant discrepancy between the domain formulated by the dataset and the real network. An online learning method allows the agent to be trained directly with the real network component. However, the state space in the agent might not be traversed completely when operating a network component in normal conditions. As a result, when some exceptions or disruptive events occur, the state, which is inputted into the agent, might not be seen before that. Consequently, the generated action could be relatively random and the behaviour in such conditions cannot be well emulated. To solve this issue, the example embodiment is configured to use an autoencoder to augment the state space from existing transitions, and use Gaussian Process Regression (GPR) to determine the reward of these augmented states accordingly as shown in Fig. 6. Fig. 6 illustrates a training process 600, VAE base state augmentation 602 that feeds the agent 200, 201. The GP local reward estimation 602 follows the agent 200, 201 and feeds the training process 600.

The DRL agent 200 that is trained for existing transitions may not be robust for other unseen states, because the DRL agent 200 is trained with seen transitions. The example embodiment of Fig. 6 is configured to augment the seen transitions, for example expand the transition dataset. The challenge is then when the state is generated randomly, there is not reward, because the accurate reward may only be obtained from real network/system. Consequently, the example embodiment of Fig. 6 is configured to generate similar states from seen transitions using the autoencoder architecture. To obtain the reward, the example embodiment of Fig. 6 uses the GPR to estimate or predict the reward. This example embodiment may improve the robustness of the DRL agent 200 when it mimic the real network components 203.

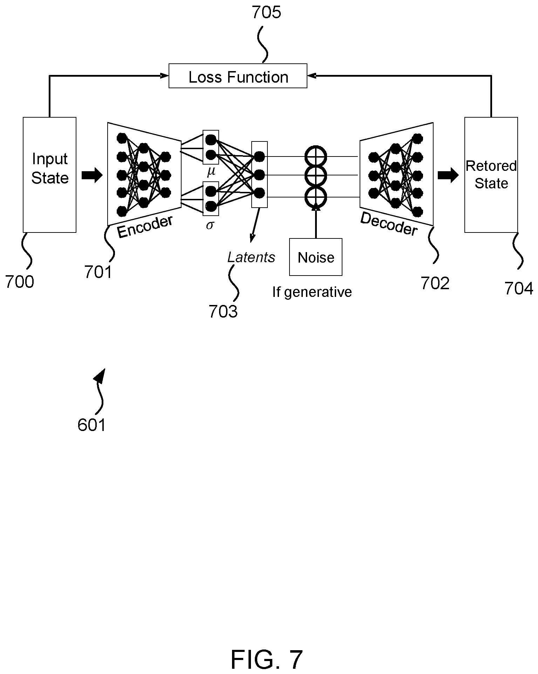

Fig. 7 illustrates a block diagram of state augmentation 601 according to an example embodiment.

State augmentation 601 is configured by leveraging an autoencoder architecture to augment the limited states collected from real network components 203. The autoencoder is kind of unsupervised learning, which is usually composed of an encoder 701 and a decoder 702, where both are based on neural network architectures. The encoder 701 is used to encode the high-dim input data 700 into a concise vector (denoted as latent vector 703). The decoder 702 is designed to decode the latent-vector 703 back to the original input data 704. As there is no need of labels, in other words, unsupervised learning, the loss function 705, training the encoder 701 and the decoder 702, is the difference between the input data 700 and the restored data 704. As shown in Fig.7, the state augmentation 601 is configured to the variational autoencoder (VAE) to encode 701 and decode 702 the collected states 700,704 in transitions, which introduces a regularization in the loss function 705 and improves the regularization in the latent 703 space (similar latent vectors are decoded into similar input data). According to an example embodiment, the state augmentation 601 is configured to formulate a data set with all collected state spaces from a network component 203, and feed them into the VAE network for offline training. The variable vectors (µ,σ) will be generated after the training phase, where the latents 703 are sampled from the distribution defined by the variable vectors. After the training is completed (for example, if generative), the state augmentation 601 slightly changes the encoded latent vectors from the dataset, and feeds the deviated latent vectors into the decoder 702 in VAE. The decoder 702 outputs will demonstrate a similar distribution as the input states 700 collected previously. The deviated latent vectors are decoded by the decoder 702. As the vectors are changed a little bit from the encoded latent vectors, the decoder 702 will generate a similar output as compared to that of original encoded vectors. This helps to generate new states similar to the seen state, which may be configured as the state augmentation. Then, the state augmentation 601 uses them as the new states 704, and the states are augmented into the buffer for further training. In this way, the state augmentation 601 can augment the state space for training the network agents 200 or user agents 201.

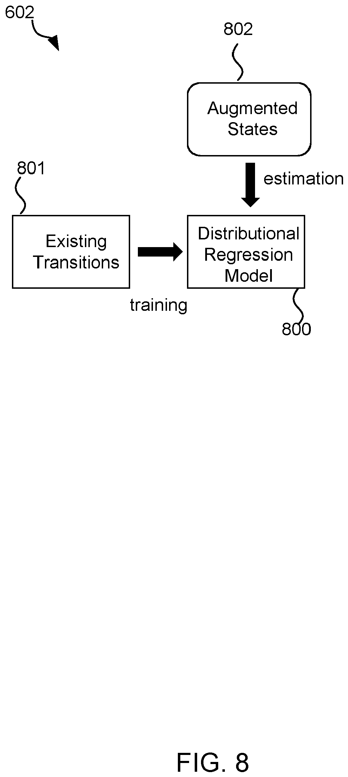

Fig. 8 illustrates a block diagram of reward estimation 602 according to an example embodiment.

With the state augmentation 601, the simulation device 100 can obtain a massive number of states, for example more than the real states that are collected from the network component 203 or user. However, the corresponding reward of these states under different actions is undetermined. Usually, the real reward can only be obtained when this action is taken into the network component 203 under this exact state. According to the example embodiment, one of the objects is to achieve a robust emulation with the DRL agents 200, for example to make sure the agent 200 will not generate unusual or unexpected actions under different states. Consequently, one may roughly estimate the reward without the exact value. Building a reward estimator that estimates all the rewards under all states and actions requires a substantial amount of real transitions and fails to have accurate estimation locally. As shown in the example embodiment of Fig.8, the reward estimation 602 is configured to use a distributional regression model 800 to build the regression model only with local data points, for example similar state and action pairs. For example, Gaussian Process Regression (GPR) uses kernel functions to approximate the distribution of the reward values. The reward estimation 602 is configured to the GPR to take the state and action together as the inputs, and the reward values as the outputs. As there is a limited number of local data points used in GPR, the regression training of GPR is fast and accurate locally. In this way, the reward values of augmented states are roughly estimated. In an example embodiment, the reward estimation 602 trains the distributional regression model by using existing transitions 801, for example state-action as inputs and rewards as a ground-truth label. These transitions are collected from the real network component 203 or user; however, these transitions are limited. Once the distributional regression model is well trained (offline processing), the reward estimation 602 is configured to feed the augmented states 802 into the model 800, which will generate reward estimation for them. Finally, the reward estimation 602 obtains sufficient transitions, either collected from the real network or generated from state augmentation 601. The simulation device 100 can use them to train the DRL agents 200 to achieve more robust performance when they are inferencing.

An example embodiment for a network simulator for End-to-End Network Slicing is described next. In this example, there is applied the network simulator device 100 to the end-to-end network slicing scenario. Considering the whole network being composed of X BSs, Y switches, and Z core network functions. Meanwhile, the interconnections between these network components are given. There are N network slices running on this end-to-end network.

To this end, multiple DRL agents 200 are created and trained to mimic the network components 201 and network slices. For the BS emulation, the inner state space is configured as follows: [CQI, RLC buffer, HARQ status, AMC, MAC user-to-PRB mapping, scheduler, Active Queue Management Status, Channel Fading] and the outer state as [traffic of a slice, user location, mobility].

It is worthy to note that these states can be expanded according to the needs of the simulation. Comprehensive information is intended to be obtained about the network component 203.

For the slice emulation, the inner state space is configured as: [the TCP/IP transmission buffer, packet retransmission, application status, slice template metrics]. The action space is then defined according to the metrics of the slice service level agreement, such as [throughput of slice, per user throughput, delay, reliability, etc.].

Once the state space and action space are well defined, then the simulator device 100 may train these DRL agents 200 with their corresponding network components 201 and network slices.

A device 100 may comprise means for performing any aspect of the method(s) described herein. According to an example embodiment, the means comprises at least one processor, and memory comprising program code, the at least one processor, and program code configured, when executed by the at least one processor, to cause performance of any aspect of the method.

The functionality described herein can be performed, at least in part, by one or more computer program product 103 components such as software components. According to an example embodiment, the device 100 comprises a processor 101 configured by the program code when executed to execute the example embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), and Graphics Processing Units (GPUs).

Any range or device value given herein may be extended or altered without losing the effect sought. Also any example embodiment may be combined with another example embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one example embodiment or may relate to several example embodiments. The example embodiments are not limited to those that solve any or all of the stated problems or those that have any or all of the stated benefits and advantages. It will further be understood that reference to 'an' item may refer to one or more of those items.

The operations of the methods described herein may be carried out in any suitable order, or simultaneously where appropriate. Additionally, individual blocks may be deleted from any of the methods without departing from the spirit and scope of the subject matter described herein. Aspects of any of the example embodiments described above may be combined with aspects of any of the other example embodiments described to form further example embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various example embodiments have been described above with a certain degree of particularity, or with reference to one or more individual example embodiments, those skilled in the art could make numerous alterations to the disclosed example embodiments without departing from the spirit or scope of this specification.

## Claims

1. A device (100) for simulating a wireless network, comprising:
at least one processor (101); and
at least one memory (102) including computer program code;
the at least one memory and the computer program code configured, with the at least one processor, to cause the device (100) to:
configure deep reinforced learning, DRL, agents (200), wherein each DRL agent is configured to emulate an operation of a component (203) of the wireless network, and each DRL agent is configured to states (400,401) representing information of the wireless network and information of the component;
wherein the DRL agents are configured to receive and execute training data so that the states are augmented (601) and reward estimated (602);
inter-connect the DRL agents to emulate real connections between the components in the wireless network; and
execute the DRL agents based on the states as inputs to simulate the wireless network online.

2. The device (100) according to claim 1, wherein each DRL agent is configured to emulate an individual component in a real wireless network, wherein the component comprises the individual component and the wireless network comprises the real wireless network implemented in a certain geographical area.

3. The device (100) according to claim 1 or claim 2, wherein the states comprise an inner state (400) representing technical inner information of the component and wherein each DRL agent is configured to receive the inner state as an input.

4. The device (100) according to any preceding claim, wherein the states comprise an outer state (401) representing a wireless network user status and states of other DRL agents, and wherein each DRL agent is configured to receive the outer state as an input.

5. The device (100) according to any preceding claim, wherein each DRL agent is further configured to output a next inner state based on said states, the next inner state representing a network configuration of the DRL agent based on said states.

6. The device (100) according to any preceding claim, further comprising a user agent configured to emulate operations of a user device of the wireless network, and the user agent configured to generate data traffic of the wireless network and performances of the user within the wireless network.

7. The device (100) according to claim 6, wherein the DRL agents are configured to receive the data traffic and the performances of the user within the wireless network.

8. The device (100) according to claim 6, wherein the user device comprises a mobile device.

9. The device (100) according to any preceding claim, wherein for augmenting, the device is further configured to use an autoencoder to augment the states.

10. The device according to claim 9, wherein the autoencoder comprises a variational autoencoder, VAE.

11. The device (100) according to any preceding claim, wherein for the reward estimating the device is further configured to use distributional regression.

12. The device (100) according to claim 11, wherein the device is configured to gaussian process regression, GPR, for the reward estimation.

13. The device (100) according to any preceding claim, wherein the device is configured to augment the states so that a massive number of states is obtained for the DRL agent; and
wherein the device is configured to reward estimate the massive number of states by distributional regression based on similarity of the states.

14. A method for simulating a wireless network, comprising:
configuring (300) deep reinforced learning, DRL, agents, wherein each DRL agent is configured to emulate an operation of a component of the wireless network, and each DRL agent is configured to states representing information of the wireless network and information of the component;
receiving and executing (301,302), by the DRL agents, training data so that the states are augmented and reward estimated;
inter-connecting (303) the DRL agents to emulate real connections between the components in the wireless network; and
executing (304) the DRL agents based on the states as inputs to simulate the wireless network online.

15. A computer program product comprising program code configured to perform the method according to claim 14 when the computer program product is executed on a computer.
